# EUROPÄISCHE PATENTSCHRIFT

(11) **EP 2 401 419 B1**
(45) Veröffentlichungstag und Bekanntmachung des Hinweises auf die Patenterteilung: **03.01.2018**
(21) Anmeldenummer: 09780091.6
(22) Anmeldetag: 02.07.2009
(51) Int. Cl.: C23C 28/00, C23C 28/04, C23C 14/06, C23C 14/22, C22C 27/02

(54) **SCHICHTSYSTEM SOWIE BESCHICHTUNGSVERFAHREN ZUR HERSTELLUNG EINES SCHICHTSYSTEMS**
COATING SYSTEM AND METHOD FOR MAKING IT
SYSTÈME DE COUCHE ET PROCÉDÉ DE REVÊTEMENT POUR LA PRODUCTION D'UN SYSTÈME DE COUCHE

(30) Priorität: 27.02.2009 EP 09153956
(43) Veröffentlichungstag der Anmeldung: 04.01.2012
(73) Patentinhaber: Oerlikon Surface Solutions AG, Pfäffikon, 8808 Pfäffikon (CH)
(72) Erfinder: VETTER, Jörg, 51469 Bergisch Gladbach (DE); ERKENS, Georg, 52070 Aachen (DE)
(74) Vertreter: Intellectual Property Services GmbH
(86) Internationale Anmeldenummer: PCT/EP2009/058322
(87) Internationale Veröffentlichungsnummer: WO 2010/097124

(56) Entgegenhaltungen:
- EP-A1- 0 093 706
- EP-A1- 1 783 245
- EP-A2- 1 932 947
- EP-A2- 2 022 870

## Beschreibung

Die Erfindung betrifft ein Schichtsystem zur Bildung einer Oberfläche auf einem Substrat, insbesondere auf einer Oberfläche eines Werkzeug, im Speziellen eines Werkzeugs für die Umformung, sowie ein Verfahren für die Herstellung eines Schichtsystems gemäss dem Oberbegriff des unabhängigen Anspruchs der jeweiligen Kategorie.
Die Herstellung leistungsfähiger Werkzeuge und Bauteile wird meistens durch eine Beschichtung von deren Oberflächen realisiert. Eine wichtige Klasse solcher beschichteten Substrate sind Werkzeuge, neben anderen insbesondere Werkzeuge für die Umformung, aber auch zerspanende Werkzeuge sowie Bauteile, vor allem Verschleissteile für Maschinen in allen möglichen Ausführungsformen. Typische Substratmaterialien, die beschichtet werden, sind unter anderem Werkzeugstähle und Hartmetalle, aber auch alle möglichen anderen Substratmaterialien.
Ein bekanntes Problem beim Beschichten dieser Werkstoffe ist dabei, dass beide eine hohe Oxidationsrate an Luft bereits um 500°C aufweisen und bereits bei relativ niedrigen Temperaturen (ca. HSS 550°C, Hartmetall 650°C) erweichen. Beim Umformen jedoch kommt störend hinzu, dass neben Abrasionsverschleiß auch Aufschmierungen des zu verarbeitenden Materials sich störend auswirken. Aus diesem Grunde werden die Werkzeugoberflächen mit geeigneten Schutzschichten versehen, die sowohl die Abrasionsvorgänge als auch die Aufschmierungen deutlich senken können.
Die aus dem Stand der Technik bekannten Hartstoffschichten basieren dabei häufig auf klassischen Verbindungen wie TiN, TiNC, CrN abgeschiedren mittels PVD-Verfahren oder CVD-Verfahren. Derartige Schichten können für hoch belastete Werkzeuge nur bedingt eingesetzt werden. Diese bekannten Hartschichten haben in Bezug auf ihren Einsatzbereich aufgrund ihrer speziellen physikalischen Eigenschaften daher ihre Grenzen, vor allem bezüglich der Temperaturbelastbarkeit. Einerseits sinkt nämlich die Härte bei erhöhten Temperaturen merklich ab, andererseits setzt bereits bei relativ niedrigen Temperaturen eine Oxidation ein, die zu erhöhtem Schichtverschleiß bei der Einsatztemperatur führen kann.
Um diese Probleme zu umgehen wurden im wesentlichen zwei Schichtklassen entwickelt, die eine Oxidationsbeständigkeit im Bereich bis zu 1000 °C aufweisen und auch bezüglich der Härte verbesserte Eigenschaften haben.
Die eine Schichtklasse betrifft Al-haltige Basisschichten wie AITiN und AICrN, wobei, je nach Anforderung zusätzliche Elemente hinzulegiert werden können. Typische Verbindungen aus diesem Bereich sind Verbindungen der Form AlTiXNCO, wobei X z.B. Cr oder ein anderes Metall ist. Derartige Schichten weisen sowohl bei der Zerspanung als auch bei der Umformung eine Leistungssteigerung gegenüber abrasivem Verschleiß auf. Die ist aus der positiven Veränderung sowohl der Härtesteigerung bei der Einsatztemperatur, als auch der der Erhöhung der Oxidationsbeständikeit abzuleiten.
Ein anderer im Stand der Technik beschrittener Weg zur Leistungssteigerung beschichteter Werkzeuge(vorrangig von zerspanenden Werkzeugen) besteht in der Kombination von klassischen Hartstoffschichten als Trägerschicht kombiniert mit Finish-Schichten als Funktionsschicht. Insbesondere sind hier als Finish-Schichten die Si-haltigen Schichten (ca. 1 - 20at%; at% bedeutet dabei im Rahmen dieser Anmeldung "Atomprozent") des Typs MeSiXNCO-Schicht (X weitere Metalle oder B) wie TiSiN zu nennen, die eine weitere deutlich verbesserte Temperaturbelastung ermöglichen. Diese Schichten werden meist bei der Trockenzerspanung von gehärteten Stählen eingesetzt.

Leistungspotentiale sind bei diesen Schichten sicher auch beim Stanzen zu erwarten.
Die im nachfolgenden Abschnitt genannten Hartschichtsysteme sind Systeme, die speziell für spannende Werkzeuge appliziert werden.
Es ist weiterhin beispielsweise bekannt, oxidische Keramikschichen wie Al₂O₃ mittels CVD-Verfahren auf Wendeschneidplatten abzuscheiden, um den Verschleißprozessen bei erhöhten Kontakttemperaturen, insbesondere beim Drehen begegnen zu können.
Im Stadium der Erforschungen sind darüber hinaus Bor-basierte Schichten, wie zum Beispiel B₄C oder auch kubische BN Schichten. Allerdings hat kubisches BN den entscheidenden Nachteil, dass es äußert kompliziert darstellbar ist. Dies ist vor allem durch Schwierigkeiten beim Schichtwachstum selbst, aber auch durch die hohen Eigenspannungen in den Schichten bedingt.
Allen bisherigen Bemühungen zum Trotz ist es aber nur teilweise gelungen, PVD oder CVD-Beschichtungen zur Verfügung zu stellen, die den immer höheren Anforderungen an die mechanischen Eigenschaften, wie zum Beispiel Härte, Druckeigenspannungen und Zähigkeit, tribologische Eigenschaften wie Adhäsionsneigung bei höheren Temperaturen sowie Reibung, die Oxidationsresistenz, Phasenstabilität und anderen charakteristischen Eigenschaften, vor allem auch bei hohen Flächenpressungen, die in der Umformung auftreten, gerecht zu werden. Eine bekannte Lösung ausgewählte hochbelastete Umformwerkzeuge erfolgreich zu behandeln, ist das TD-Verfahren (Toyota-Diffusionsverfahren). Das Salzbadverfahren wird dabei im Temperaturbereich von ca. 870 °C bis ca. 1030 °C zur Erzeugung einer Diffusionsschicht auf der der Basis von VC ausgeführt. Dieses Verfahren läuft also bei einer Behandlungstemperatur ab, die oberhalb der typischen Anlaßtemperatur von Werkzeugstählen liegt (meist zwischen 500 und 550 °C). Auf die bekannten Nachteile der Salzbadverfahren, wie z.B. den notwendigen Spülprozess nach der Behandlung, soll nicht weiter eingegangen werden.
Weiterhin ist bekannt mittels der PVD-Verfahren VCN-Schichten abzuscheiden. Die Patentanmeldung JP2005046975 A beschreibt eine Schicht für Werkzeuge, die aus einer Unterschicht bestehend aus VNC, die direkt auf ein Schneidwerkzeug aufgebracht wird. Anschließend wird eine weitere Verschleißschutzschicht abgeschieden.
In Surface Science 601(2007) 1153-1159, A. Glaser et.al Oxidation of vanadium nitride and titanium nitride coatings , wird das Oxidationsverhalten von VN und TiN untersucht, dabei wird festgestellt, dass VN bereits bei relativ niedrigen Temperaturen eine geschlossene homogene Oxidschicht ausbildet. Die Oxidschicht ist entsprechend der tribologischen Erfahrung in der Lage Adäsionsvorgänge (Aufschmierungen) zwischen Werkstückmaterial (z.B. Stahlblech) und beschichtetem Werkzeug zu unterbinden oder zumindest zu reduzieren.
Die EP 2 022 870 A2 beschreibt ein Schichtsystem zur Bildung einer Oberfläche auf einem Substrat, eine Verdampfungsquelle zur Herstellung eines Schichtsystems, sowie ein Substrat, insbesondere ein Werkzeug mit einem Schichtsystem. gemäss dem Oberbegriff des unabhängigen Anspruchs der jeweiligen Kategorie. Dabei werden die entsprechenden Substrate mit einer ersten Hartschicht der Zusammensetzung (MoSipAq)G, also mit einer Schicht der Zusammensetzung (MoSipAYq)[gamma] (NrCsOt)[delta] beschichtet werden, wobei G wie angegeben in an sich bekannter Zusammensetzung mindestens ein Element aus der Gruppe Stickstoff (N), Kohlenstoff (C) und Sauerstoff (O) ist, und M mindestens ein Metall aus der Gruppe der chemischen Elemente bestehend aus Aluminium (AI) und den Elementen aus den Nebengruppen IVb, Vb, Vlb des Periodensystems der Elemente ist.
Die Aufgabe der Erfindung ist es daher, eine verbesserte Beschichtung für ein Substrat, insbesondere für ein Werkzeug, insbesondere Umformwerkzeug, oder ein Verschleissteil bereitzustellen, die die aus dem Stand der Technik bekannten Probleme überwindet, und insbesondere ein sich tribologisch positiv auswirkendes Oxidationsverhalten und Phasenstabilität, verbesserte mechanische Eigenschaften, vor allem, aber nicht nur, in Bezug auf die Härte und Druckeigenspannungen aufweist und bei Temperaturen abscheidbar ist, die die Anlaßtemperatur der eingesetzten Stähle nicht überschreitet.
Eine weitere Aufgabe der Erfindung ist es, ein Verfahren zur Herstellung einer solchen verbesserten Beschichtung bereitzustellen.
Die diese Aufgaben lösenden Gegenstände der Erfindung sind durch die Merkmale der jeweiligen unabhängigen Ansprüche gekennzeichnet.

Die abhängigen Ansprüche beziehen sich auf besonders vorteilhafte Ausführungsformen der Erfindung.
Die Erfindung betrifft somit ein Schichtsystem zur Bildung einer Oberflächenschicht auf einer Oberfläche eines Substrats, insbesondere auf der Oberfläche eines Werkzeugs, insbesondere auf der Oberfläche eines Umformwerkzeugs, wobei das Schichtsystem mindestens eine erste Oberflächenschicht der Zusammensetzung
- (V₉₇Zr₃)_{α}(N)_{β}
- (V₉₇Zr₃)_{α}(N₅₀C₅₀)_{β}
- (V₉₅Ni₅)_{α}(N₆₅C₃₀O₅)_{β}
- (V₉₆Ce₄)_{α}(N₂₅C₆₅O₁₀)_{β}
- (V₉₇Zr₁ Si₁B₁)_{α}(N)_{β}
umfasst, mit der Summe aller Atome in der Schicht (α+β) =100 at%, wobei 40 ≤α ≤ 80 at% gilt.

Besonders vorteilhaft gilt für den Parameter α die Relation 40 ≤ α ≤ 60, im Speziellen 45 ≤ α ≤ 55, und bevorzugt α ≈ 50.
Dabei betrifft die Erfindung auch Schichtsysteme, bei welchen zwischen der Oberflächenschicht und dem Substrat eine weitere Teilschicht vorgesehen ist, die insbesondere eine unmittelbar auf der Oberfläche des Substrats aufgebrachte Haftschicht ist.
Die Teilschicht ist in einem speziellen Ausführungsbeispiel eine Haftschicht der Zusammensetzung V₉₇Zr₃, und / oder eine Haftschicht der Zusammensetzung V₈₀Zr₂₀.

In einem anderen Ausführungsbeispiel der vorliegenden Erfindung hat die Teilschicht die Zusammensetzung (Al₅₅Ti₄₅)_{γ}N_{δ}, mit γ+δ =100 at% und 40 ≤ γ ≤ 60, wobei bevorzugt γ ≈ 50 ist, und die Teilschicht insbesondere eine Haftschicht, im Speziellen eine unmittelbar auf dem Substrat aufgebrachte Haftschicht ist.

Ein weiteres Ausführungsbeispiel betrifft eine Teilschicht der Zusammensetzung (Al₆₉Cr₂₉Mg₁Si₁)_{γ}N_{δ}, mit γ+δ =100 at% und 40≤ γ ≤ 60, und bevorzugt γ ≈ 50, wobei die Teilschicht insbesondere eine Haftschicht, im Speziellen eine unmittelbar auf dem Substrat aufgebrachte Haftschicht ist.

Vorteilhaft kann die Teilschicht auch die Zusammensetzung (Al₆₀Cr₃₀M₉₅Si₅)_{γ}N_{δ} haben, mit γ+δ =100 at% und 40 ≤ γ ≤ 60, und bevorzugt γ ≈ 50, wobei die Teilschicht insbesondere eine Haftschicht, im Speziellen eine unmittelbar auf dem Substrat aufgebrachte Haftschicht ist.

In einem anderen Fall hat die Teilschicht die Zusammensetzung (Cr₉₁ Ni₃Al₃Si₃)_{γ}N_{δ}, mit γ+δ =100 at% und 40 ≤ γ ≤ 60, und bevorzugt γ ≈ 50, wobei die Teischicht insbesondere eine Haftschicht, im Speziellen eine unmittelbar auf dem Substrat aufgebrachte Haftschicht ist.

Dabei deckt die Erfindung auch weitere Teilschichten mit anderen chemischen Zusammensetzungen ab. So kann die Teilschicht auch eine TiN und / oder eine Cr Teilschicht, insbesondere eine Haftschicht, im Speziellen eine unmittelbar auf dem Substrat aufgebrachte Haftschicht sein.

Zur Optimierung der Eigenschaften der Gesamtschicht, können die Teilschichten aus dem Fachmann bekannten Gradientenschichten, z.B. TiCrN mit zunehmenden Cr Gehalt startend von der Substratoberfläche, oder mehrlagigen Schichten, z.B Cr/CrN als Schichtfolge in der Teilschicht, bestehen.

Ein Schichtsystem und / oder eine Teilschicht und /oder eine Oberflächenschicht der vorliegenden Erfindung kann eine Härte von zum Beispiel HK 0,025 zwischen 1500 und 3500 haben, im Speziellen eine Härte HK 0,025 zwischen 1900 und 3100, insbesondere eine Härte HK 0,025 zwischen 2100 und 2900 haben.
Eine Dicke des Schichtsystems und / oder der Teilschicht und /oder der Oberflächenschicht kann vorteilhaft zwischen 0,01 µm und 100 µm liegen, im Speziellen zwischen 0,1 µm und 8 µm, und liegt bevorzugt zwischen 0,2 µm und 7,5 µm, wobei das Schichtsystem eine Oberflächenrauhigkeit R_{z} zwischen 0,2 µm und 10 µm, insbesondere zwischen 0,5 µm und 5 µm, bevorzugt zwischen 0,5 µm und 1,5 µm aufweist, und / oder eine Haftfestigkeit des Schichtsystems und / oder der Teilschicht und /oder der Oberflächenschicht im Bereich von HF 1 bis HF 3 liegt, im speziellen HF2 und bevorzugt HF1 ist.
Die Erfindung betrifft des weiteren ein Beschichtungsverfahren zur Herstellung eines Schichtsystems der vorliegenden Erfindung, wobei das Beschichtungsverfahren ein PVD-Verfahren, bevorzugt ein Lichtbogenbeschichtungsverfahren, wie ein ARC-Verfahren, ein Sputterverfahren oder ein Kombinationsverfahren aus Lichtbogenbeschichtungsverfahren und Sputterverfahren ist.

Zum besseren Verständnis der Erfindung zeigt Tabelle 1 die erfindungsgemäßen Beispiele. Ziel der Erfindung war es die Härte und somit die Abrasionsbeständigkeit reiner PVD Schichten auf der Basis VN, VNC ohne Reduzierung der Haftung auf den zu beschichtenden Teilen zu verbessern. Das teilweise Substituieren von V-Atomen durch Zr odere andere Metalle erhöhte die Härte um ca. 10 %, hier näher betrachtet bei der Zr-Substitution im Falle einer nitridischen Schicht Beispiele 1 sowie Beispiel 2 zu Vergleichsbeispiel A.
Die folgende Tabelle zeigt einige ausgewählte Ausführungsbeispiele erfindungsgemässer Oberflächenschichten.

**Tabelle 1: Eine Auswahl erfindungsgemässer Schichtsysteme mit wichtigen Schichtparametern, Härtemessung Knoophärte HK0.025, Haftungstest HRC 150 kp (VDI 3824) auf HSS der Härte 66 HRC.**

| Unterschicht | Funktionsschicht | Härte | Dicke Unterschicht/Funktion | Haftung |
|---|---|---|---|---|
| Beispiel 1 | (V₉₇Zr₃)_{α}N_{β} | | | HF1 |
| V₉₇Zr₃ | | 2129 | 0.2µm/7,1 µm | |
| | α/β ca. 1 | | | |
| Beispiel 2 | (V₉₇Zr₃)_{α}N_{β} | 2150 | 0/7 µm | HF 2 |
| | α/β ca. 1 | | | |
| Beispiel 3 | (V₉₇Zr₃)_{α}(CᵤNᵥ)_{β} | 2879 | 5µm | HF3 |
| | u = 50, v=50 | | | |
| | α/β ca. 1 | | | |
| Beispiel 4 | | | | |
| (Al₅₅Ti₄₅)_{α}N_{β} | (V₉₅Ni₅)_{α}(CᵤNᵥO_{w})_{β} | 2730 | 3µm/4,5 µm | HF2 |
| α/β ca. 1 | u=30, v=65, w=5 | | | |
| | α/β ca. 1 | | | |
| Beispiel 5 | | | | |
| | (V₉₆Ce₄)_{α}(CᵤNᵥO_{w})_{β} | 3035 | 2.5 µm /4 µm | HF3 |
| (Al₆₉Cr₂₉Mg₁Si₁)_{α}N_{β} | u=65, v=25, w=1 0 | | | |
| α/β ca. 1 | α/β ca. 1 | | | |
| Beispiel 5 | (V₉₇Zr₁Si₁B₁)_{α}N_{β} | 2210 | 0/4 µm | HF2 |
| | α/β ca. 1 | | | |

Anwendungsbereiche für Schichtsysteme der vorliegenden Erfindung sind insbesondere Umformwerkzeuge, insbesondere für die Halb- und Warmumformung, Giesswerkzeuge, insbesondere für Aluminiumdruckguss, Zerspanungswerkzeuge, insbesondere bei rostfreien Stählen, aber auch Werkzeuge für die Kunststoffverarbeitung, sowie Motorenelemente, insbesondere Kolbenringe, bzw. Turbinenelemente und Pumpenelemente, insbesondere bewegliche Teile.

Im Folgenden wird ein besonders bevorzugtes Verfahren zur Herstellung eines erfindungsgemässen Schichtsystems für ein Umformwerkzeug angegeben:

### Beispiel: Werkzeugtest Umformwerkzeug

Werkzeugstahl: DIN 1.2379
1. Werkzeug wurde plasmanitriert Nitrierhärtetiefe ca. 100 µm
2. Politur des Werkzeuges
3. Heizen/Ionenreinigung
   Heizen auf 400 °C
   10 min AEGD Ionenreinigung mit Ar, 200 V
   3 min Metallionenbombardement mit VZr 1000 V
4. Beschichtung mit 200 V
   - 200 nm VZr Schicht
   - 7,1 µm VZrN-Schicht, Reaktivgas Stickstoff 5 Pa
5. Ergebnis HF-Klasse 1
6. Politur der Schicht auf R_{z} 0.9 um

### Anwendungsbeispiel

Umzuformendes Material: hochfester Stahl (JIS: SAPH400)
Materialdicke: 2-3 mm
Presskraft: 3000 t

### Ergebnis des Standzeittestes:

PVD Beschichtung (CrN): 1000 Hübe
CVD-Beschichtung (TiC): 4000 Hübe
VZrN-Beschichtung entsprechend Beispiel 1: 7 200 Hübe
(Untersuchungsstatus - kein Standzeitende)

In der Zeichnung sind weitere bevorzugte Ausführungsbeispiele der Erfindung angegeben. Es zeigen:
- Fig. 1a - 1c:: ein Schliff mittels einer Kalotte an einer Oberfläche eines erfindungsgemässen Beschichtungssystems.
- Fig. 2 - 4:: Ausführungsbeispiele von Zweischichtsystemen;
- Fig. 5:: Ausführungsbeispiele mit mehr als zwei Schichten

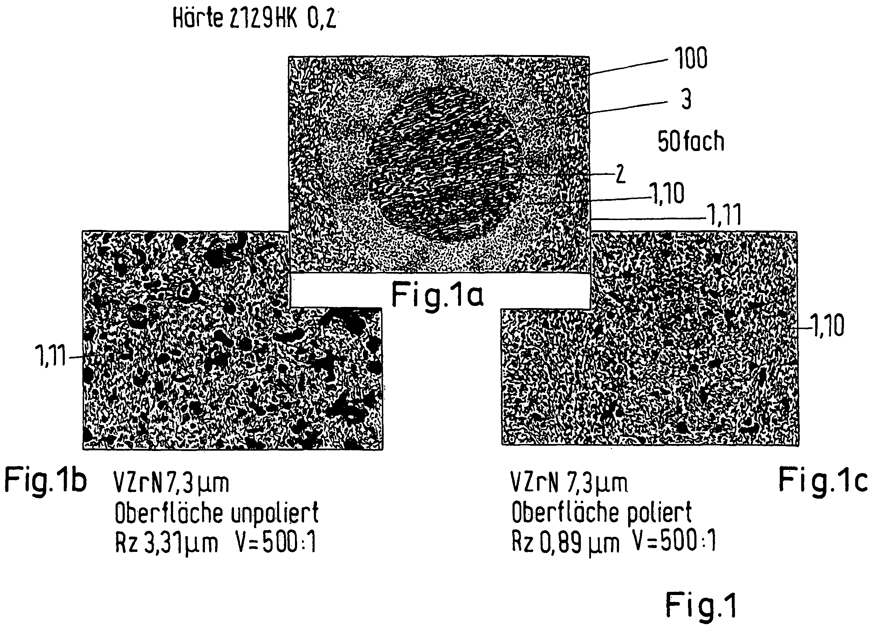

In Fig. 1, die Teilfiguren 1a - 1c umfasst, ist eine Aufnahme der Oberfläche eines beschichteten Substrats 100 zu sehen, das mittels einer Kalotte in an sich bekannter Weise poliert wurde. Fig. 1a zeigt den Schliff in 50 facher Vergrösserung, Fig. 1b und 1c je einen Oberflächenbereich in 500 facher Vergrösserung.

In Fig. 1a ist der mittlere kreisförmige Bereich 2 ein frei polierter Oberflächenbereich des Substrats 100, der keine Beschichtung mehr aufweist. Der Kreisring 3 ist ein polierter Bereich 1,10 der erfindungsgemässen Oberflächenbeschichtung 1. Der äussere Bereich 1, 11 ist ein unpolierter Oberflächenbereich. Wesentliche physikalische Parameter der Oberflächenbereiche sind in der Zeichnung angegeben. Die Haftfestigkeit der Schicht ist HF 1.

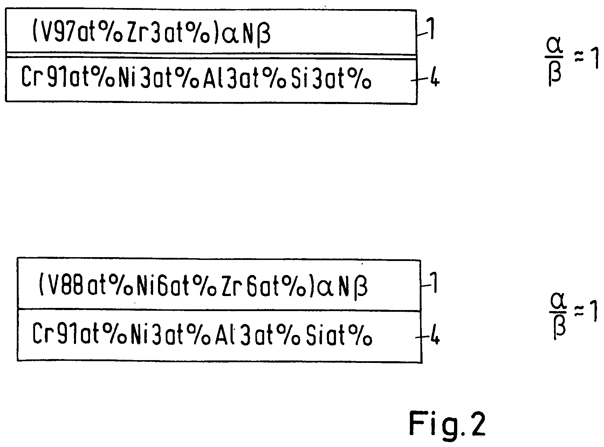

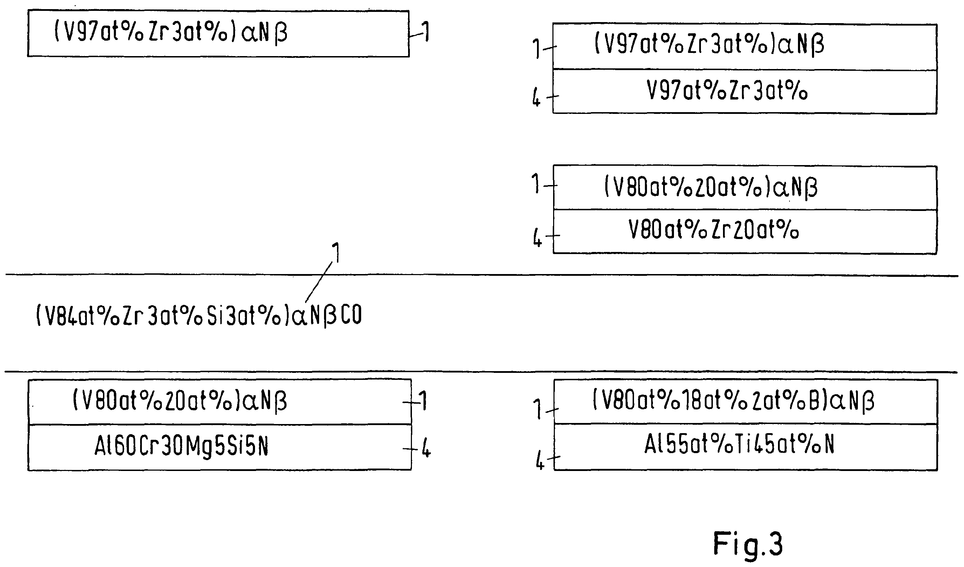

Die Fig. 2 bis 5 zeigen Ausführungsbeispiele mit zwei und mehr Teilschichten 4, die stöchiometrisch und nicht stöchiometrisch sein können. Die jeweiligen chemischen Zusammensetzungen der Schichtsysteme bzw. Teilschichten sind angegeben.

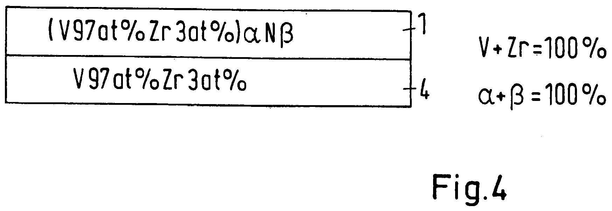

Fig. 4 zeigt ein erfindungsgemässes Testbeispiel mit der angegeben Kathodenzusammensetzung V97at%Zr3at%.

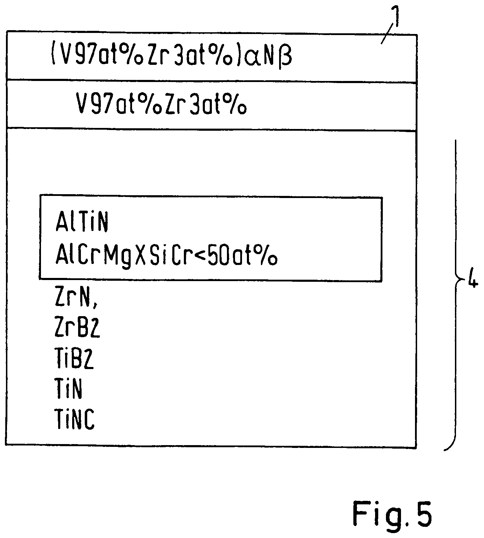

Fig. 5 zeigt ein Schichtsystem, das typischerweise für Umformwerkzeuge einsetzbar ist mit verschiedenen möglichen Unterschichten, deren mögliche Zusammensetzungen in Fig. 5 angegeben sind. Dabei sind die Zusammensetzungen verschiedener möglicher Unterschichten 4 schematisch eingezeichnet. Die durch Umrandung gekennzeichneten Al-Schichten zeigen dabei insbesondere gute thermische Isolationseigenschaften aufgrund schlechter thermischer Leitfähigkeit.

## Patentansprüche

1. Schichtsystem zur Bildung einer Oberflächenschicht auf einer Oberfläche eines Substrats (100), insbesondere auf der Oberfläche eines Umformwerkzeugs,
**dadurch gekennzeichnet, dass**
das Schichtsystem mindestens eine erste Oberflächenschicht der Zusammensetzung
- (V₉₇Zr₃)_{α}(N)_{β}
- (V₉₇Zr₃)_{α}(N₅₀C₅₀)_{β}
- (V₉₅Ni₅)_{α}(N₆₅C₃₀O₅)_{β}
- (V₉₆Ce₄)_{α}(N₂₅C₆₅O₁₀)_{β}
- (V₉₇Zr₁ Si₁B₁)_{α}(N)_{β}
umfasst, mit der Summe aller Atome in der Schicht (α+β) =100 at%, wobei 40 ≤α ≤ 80 at% gilt.

2. Schichtsystem nach Anspruch 1, wobei 45 ≤ α ≤ 55 ist.

3. Schichtsystem nach einem der vorangehenden Ansprüche, wobei α ≈ 50 ist.

4. Schichtsystem nach einem der vorangehenden Ansprüche, wobei zwischen der Oberflächenschicht und dem Substrat eine weitere Teilschicht vorgesehen ist, die insbesondere eine unmittelbar auf der Oberfläche des Substrats aufgebrachte Haftschicht ist.

5. Schichtsystem nach Anspruch 4, wobei die Teilschicht eine Haftschicht der Zusammensetzung V₉₇Zr₃ ist.

6. Schichtsystem nach Anspruch 4 wobei die Teilschicht eine Haftschicht der Zusammensetzung V₈₀Zr₂₀ ist.

7. Schichtsystem nach Anspruch 4 wobei die Teilschicht die Zusammensetzung (Al₅₅Ti₄₅)_{γ}N_{δ} ist, mit γ+δ =100 at% und 40 ≤ γ ≤ 60, und bevorzugt γ ≈ 50 hat, und insbesondere eine Haftschicht, im Speziellen eine unmittelbar auf dem Substrat aufgebrachte Haftschicht ist.

8. Schichtsystem nach Anspruch wobei die Teilschicht die Zusammensetzung (Al₆₉Cr₂₉Mg₁Si₁)_{γ}N_{δ} ist, mit γ+δ =100 at% und 40≤ γ ≤ 60, und bevorzugt γ ≈ 50 hat, und insbesondere eine Haftschicht, im Speziellen eine unmittelbar auf dem Substrat aufgebrachte Haftschicht ist.

9. Schichtsystem nach Anspruch wobei die Teilschicht die Zusammensetzung (Al₆₀Cr₃₀Mg₅Si₅)_{γ}N_{δ} ist, mit γ+δ =100 at% und 40 ≤ γ ≤ 60, und bevorzugt γ ≈ 50 hat, und insbesondere eine Haftschicht, im Speziellen eine unmittelbar auf dem Substrat aufgebrachte Haftschicht ist.

10. Schichtsystem nach Anspruch wobei die Teilschicht die Zusammensetzung (Cr₉₁Ni₃Al₃Si₃)_{γ}N_{δ} ist, mit γ+δ =100 at% und 40 ≤ γ ≤ 60, und bevorzugt γ ≈ 50 hat, und insbesondere eine Haftschicht, im Speziellen eine unmittelbar auf dem Substrat aufgebrachte Haftschicht ist.

11. Schichtsystem nach Anspruch 4 wobei die Teilschicht eine TiN Teilschicht ist, insbesondere eine Haftschicht, im Speziellen eine unmittelbar auf dem Substrat aufgebrachte Haftschicht ist.

12. Schichtsystem nach Anspruch 4, wobei die Teilschicht eine Cr Teilschicht ist, insbesondere eine Haftschicht, im Speziellen eine unmittelbar auf dem Substrat aufgebrachte Haftschicht ist.

13. Schichtsystem nach einem der vorangehenden Ansprüche, wobei die Härte des Schichtsystems und / oder der Teilschicht und /oder die Oberflächenschicht eine Härte HK 0,025 zwischen 1500 und 3500 hat, im Speziellen eine Härte HK 0,025 zwischen 1900 und 3100 hat, insbesondere eine Härte HK 0,025 zwischen 2100 und 2900 hat.

14. Schichtsystem nach einem der vorangehenden Ansprüche, wobei eine Dicke des Schichtsystems und / oder der Teilschicht und /oder der Oberflächenschicht zwischen 0,01 µm und 100 µm liegt, im Speziellen zwischen 0,1 µm und 8 µm liegt, und bevorzugt zwischen 0,2 µm und 7,5 µm liegt.

15. Schichtsystem nach einem der vorangehenden Ansprüche, wobei die Oberflächenschicht eine Oberflächenrauhigkeit R_{z} zwischen 0,2 µm und 10 µm, insbesondere zwischen 0,5 µm und 5 µm, bevorzugt zwischen 0,5 µm und 1,5 µm aufweist.

16. Schichtsystem nach einem der vorangehenden Ansprüche, wobei eine Haftfestigkeit des Schichtsystems und / oder der Teilschicht und /oder der Oberflächenschicht von HF 1 bis HF 3 liegt, im speziellen HF2 und bevorzugt HF1 ist.

17. Beschichtungsverfahren zur Herstellung eines Schichtsystems (1) nach einem der vorangehenden Ansprüche, wobei das Beschichtungsverfahren ein PVD-Verfahren, bevorzugt ein Lichtbogenbeschichtungsverfahren, wie ein ARC-Verfahren, ein Sputterverfahren oder ein Kombinationsverfahren aus Lichtbogenbeschichtungsverfahren und Sputterverfahren ist.

## Claims

1. A layer system for the formation of a surface layer on a surface of a substrate (100), in particular on the surface of a shaping tool,
**characterized in that**
the layer system includes at least one first surface layer of the composition
- (V₉₇Zr₃)_{α}(N)_{β}
- (V₉₇Zr₃)_{α}(N₅₀C₅₀)_{β}
- (V₉₅Ni₅)_{α}(N₆₅C₃₀O₅)_{β}
- (V₉₆Ce₄)_{α}(N₂₅C₆₅O₁₀)_{β}
- (V₉₇Zr₁ Si₁B₁)_{α}(N)_{β}, with the sum of all atoms in the layer (α + β) = 100 at%, where 40 ≤ α ≤ 80 at% applies.

2. A layer system in accordance with claim 1, wherein 45 ≤ α ≤ 55.

3. A layer system in accordance with any one of the preceding claims, wherein α ≈ 50.

4. A layer system in accordance with any one of the preceding claims, wherein a further part layer which is in particular an adhesive layer applied directly to the surface of the substrate is provided between the surface layer and the substrate.

5. A layer system in accordance with claim 4, wherein the part layer is an adhesive layer of the composition V₉₇Zr₃.

6. A layer system in accordance with claim 4, wherein the part layer is an adhesive layer of the composition V₈₀Zr₂₀.

7. A layer system in accordance with claim 4, wherein the part layer is the composition (Al₅₅Ti₄₅)_{γ}N_{δ}, where γ + δ = 100 at% and 40 ≤ γ ≤ 60, and preferably γ ≈ 50, and is in particular an adhesive layer, specifically an adhesive layer applied directly to the substrate.

8. A layer system in accordance with claim 4, wherein the part layer is the composition (Al₆₉Cr₂₉Mg₁Si₁)_{γ} N_{δ}, where γ + δ =100 at% and 40≤ γ ≤ 60, and preferably γ ≈ 50, and is in particular an adhesive layer, specifically an adhesive layer applied directly to the substrate.

9. A layer system in accordance with claim 4, wherein the part layer is the composition (Al₆₀Cr₃₀Mg₅Si₅)_{γ}N_{δ}, where γ + δ =100 at% and 40 ≤ γ ≤ 60, and preferably≈ γ 50, and is in particular an adhesive layer, specifically an adhesive layer applied directly to the substrate.

10. A layer system in accordance with claim 4, wherein the part layer is the composition (Cr₉₁Ni₃Al₃Si₃)_{γ}N_{δ}, where γ + δ =100 at% und 40 ≤ γ ≤ 60, and preferably γ ≈ 50, and is in particular an adhesive layer, specifically an adhesive layer applied directly to the substrate.

11. A layer system in accordance with claim 4, wherein the part layer is a TiN part layer, in particular an adhesive layer, specifically an adhesive layer applied directly to the substrate.

12. A layer system in accordance with claim 4, wherein the part layer is a Cr part layer, in particular an adhesive layer, specifically an adhesive layer applied directly to the substrate.

13. A layer system in accordance with any one of the preceding claims, wherein the hardness of the layer system and/or of the part layer and/or of the surface layer has a hardness HK 0.025 between 1500 and 3500, specifically a hardness HK 0.025 between 1000 and 3100, in particular a hardness HK 0.025 between 2100 and 2900.

14. A layer thickness in accordance with any one of the preceding claims, wherein a thickness of the layer system and/or of the part layer and/or of the surface layer is between 0.01 µm and 100 µm, specifically between 0.1 µm and 8 µm, and is preferably between 0.2 µm and 7.5 µm.

15. A layer system in accordance with any one of the preceding claims, wherein the surface layer has a surface roughness R_{z} between 0.2 µm and 10 µm, in particular between 0.5 µm and 5 µm, preferably between 0.5 µm and 1.5 µm.

16. A layer system in accordance with any one of the preceding claims, wherein an adhesive strength of the layer system and/or of the part layer and/or of the surface layer is from HF 1 to HF 3, specifically HF 2 and preferably HF 1.

17. A coating system for the manufacture of a layer system (1) in accordance with any one of the preceding claims, wherein the coating process is a PVD process, preferably an arc coating process such as an arc process, a sputtering process or a combination process of arc coating process and sputtering process.

## Revendications

1. Un système de couches pour la formation d'une couche superficielle à la surface d'un substrat (100), en particulier à la surface d'un outil de formage, **caractérisé en ce, que** le système de couches comprend au moins une première couche superficielle de la composition
- (V₉₇Zr₃)_{α}(N)_{β}
- (V₉₇Zr₃)_{α}(N₅₀C₅₀)_{β}
- (V₉₅Ni₅)_{α}(N₆₅C₃₀O₅)_{β}
- (V₉₆Ce₄)_{α}(N₂₅C₆₅O₁₀)_{β}
- (V₉₇Zr₁ Si₁B₁)_{α}(N)_{β}
avec la somme de tous les atomes de la couche (α+β) = 100 at%, alors 40 ≤ α ≤ 80 at%.

2. Un système de couches selon la revendication 1, alors 45 ≤ α ≤ 55.

3. Un système de couches selon l'une des revendications précédentes, alors α ≈ 50.

4. Un système de couches selon l'une des revendications précédentes, dans lequel une autre couche partielle est prévue entre la couche superficielle et le substrat, qui est, en particulier, une couche adhésive appliquée directement sur la surface du substrat.

5. Un système de couches selon la revendication 4, dans lequel la couche partielle est une couche adhésive de la composition V₉₇Zr₃.

6. Un système de couches selon la revendication 4, dans lequel la couche partielle est une couche adhésive de la composition V₈₀Zr₂₀.

7. Un système de couches selon la revendication 4, dans lequel la couche partielle est la composition (Al₅₅Ti₄₅)_{γ}N_{δ}, avec γ+δ = 100 at% et 40 ≤ γ ≤ 60, et de préférence γ ≈ 50, et dans lequel la couche partielle est particulièrement une couche adhésive, spécialement une couche adhésive appliquée directement sur le substrat.

8. Un système de couches selon la revendication 4, dans lequel la couche partielle est la composition (Al₆₉Cr₂₉Mg₁Si₁)_{γ}N_{δ}, avec γ+δ = 100 at% et 40 ≤ γ ≤ 60, et de préférence γ ≈ 50, et dans lequel la couche partielle est particulièrement une couche adhésive, spécialement une couche adhésive appliquée directement sur le substrat.

9. Un système de couches selon la revendication 4, dans lequel la couche partielle est la composition (Al₆₀Cr₃₀Mg₅Si₅)_{γ}N_{δ}, avec γ+δ = 100 at% et 40 ≤ γ ≤ 60, et de préférence γ ≈ 50, et dans lequel la couche partielle est particulièrement une couche adhésive, spécialement une couche adhésive appliquée directement sur le substrat.

10. Un système de couches selon la revendication 4, dans lequel la couche partielle est la composition (Cr₉₁Ni₃Al₃Si₃)_{γ}N_{δ}, avec γ+δ = 100 at% et 40 ≤ γ ≤ 60, et de préférence γ ≈ 50, et dans lequel la couche partielle est particulièrement une couche adhésive, spécialement une couche adhésive appliquée directement sur le substrat.

11. Un système de couches selon la revendication 4, dans lequel la couche partielle est une couche partielle TiN, particulièrement une couche adhésive, spécialement une couche adhésive appliquée directement sur le substrat.

12. Un système de couches selon la revendication 4, dans lequel la couche partielle est une couche partielle Cr, particulièrement une couche adhésive, spécialement une couche adhésive appliquée directement sur le substrat.

13. Un système de couches selon l'une des revendications précédentes, dans lequel la dureté du système de couches et / ou de la couche partielle et / ou de la couche superficielle a une dureté HK 0,025 entre 1500 et 3500, spécialement une dureté HK 0,025 entre 1900 et 3100, particulièrement une dureté HK 0,025 entre 2100 et 2900.

14. Un système de couches selon l'une des revendications précédentes, dans lequel une épaisseur du système de couches et / ou de la couche partielle et / ou de la couche superficielle est entre 0,01 µm et 100 µm, spécialement entre 0,1 µm et 8 µm et de préférence entre 0,2 µm et 7,5 µm.

15. Un système de couches selon l'une des revendications précédentes, dans lequel la couche superficielle a une rugosité de la surface Rz entre 0,2 µm et 10 µm, particulièrement entre 0,5 µm et 5 µm, de préférence entre 0,5 µm et 1,5 µm.

16. Un système de couches selon l'une des revendications précédentes, dans lequel une adhérence du système de couches et / ou de la couche partielle et / ou de la couche superficielle est de HF 1 à HF 3, spécialement HF 2 et de préférence HF 1.

17. Procédé de revêtement pour la production d'un système de couches (1) selon l'une des revendications précédentes, dans lequel le procédé de revêtement est un procédé PVD, de préférence un procédé de revêtement par arc électrique, comme un procédé ARG, un procédé de pulvérisation cathodique ou un procédé combiné de procédé de revêtement par arc électrique et de procédé de pulvérisation cathodique.
